# EUROPEAN PATENT SPECIFICATION

(11) **EP 2 800 260 B1**
(45) Date of publication and mention of the grant of the patent: **11.09.2019**
(21) Application number: 12861728.9
(22) Date of filing: 24.12.2012
(51) Int. Cl.: H02M 1/32, H02M 7/5387, H02M 7/521, H02M 7/483

(54) **PROTECTION CIRCUIT FOR PROTECTING VOLTAGE SOURCE CONVERTER**
SCHUTZSCHALTUNG ZUM SCHUTZ EINES SPANNUNGSQUELLENUMRICHTERS
CIRCUIT DE PROTECTION POUR LA PROTECTION D'UN CONVERTISSEUR DE SOURCE DE TENSION

(30) Priority: 28.12.2011 KR 20110144641
(43) Date of publication of application: 05.11.2014
(73) Proprietor: Hyosung Heavy Industries Corporation, Seoul 04144 (KR)
(72) Inventor: PARK, Jung Soo, Seongnam-si Gyeonggi-do 463-751 (KR); CHOI, Jong Yun, Hwaseong-si Gyeonggi-do 445-170 (KR)
(74) Representative: Viering, Jentschura & Partner mbB Patent- und Rechtsanwälte
(86) International application number: PCT/KR2012/011363
(87) International publication number: WO 2013/100515

(56) References cited:
- JP-A- 2004 072 846
- JP-A- 2010 233 411
- JP-A- 2010 512 135
- JP-A- 2010 521 130
- US-A1- 2010 066 174
- US-A1- 2011 002 149

## Description

### Technical Field

The present invention relates to a power converting apparatus, and more particularly, to a protection circuit capable of protecting a voltage source converter in the event of a short circuit of a Direct Current (DC) side, in a power converting apparatus using a plurality of a voltage source converters.

### Background Art

In order to convert a Direct Current (DC) into an Alternating Current (AC) or convert the AC into the DC, an existing 2/3-level converter or a modular multilevel converter may be used. The modular multilevel converter is a device, of which a plurality of voltage source converters are connected in series, for converting the DC into the AC or converting the AC into the DC, by accurately controlling operation time points or switching time points of each of the voltage source converters.

In the voltage source converter, a short circuit is generated at any one of a positive side DC circuit and a negative side DC circuit, the corresponding power converting apparatus may not convert a power any more. In addition, much fault current flows to a converter circuit between the AC terminal and the DC terminal, and thus the corresponding circuit may be damaged.

Recently, considering increase of a use of a voltage type converter in high voltage and high current field, requirements of a technology for diverting an overcurrent, generated due to a DC side short circuit event, from the voltage source converter configured with a series connection.

Document US2010/0066174 discloses a power converting apparatus disposed between an AC power system, which generates an AC power, and a DC circuit, the power converting apparatus comprising:a voltage source converter comprising an Alternating Current connection terminal to connect to the AC power system and a Direct Current connection terminal to connect to the DC circuit, and comprising a converter arm unit being disposed between the DC connection terminal and the AC connection terminal and including a first voltage source converter and a second voltage source converter connecting the AC connection terminal with the DC connection terminal in series; and a semiconductor protection circuit connected to the converter arm unit in parallel.

### Detailed Description of the Invention

### Technical Problem

An object of the present invention is for safely protecting a voltage source converter included in a power converting apparatus from a DC side short circuit.

### Technical Solution

In accordance with an aspect of the present invention, there is provided a power converting apparatus according to claim 1.

Here, the semiconductor protection circuit may include at least one semiconductor switch.

In addition, a plurality of unit modules configured in a half-bridge method may be connected to converter arms corresponding to the first voltage source converter and the second voltage source converter, in series.

In accordance with another aspect of the present invention, there is provided a method for converting a power, according to claim 5.

Here, the semiconductor protection circuit may include at least one semiconductor switch.

In addition, a plurality of unit modules configured in a half-bridge method may be connected to converter arms corresponding to the first voltage source converter and the second voltage source converter, in series.

In addition, the unit modules may include a semiconductor valve consisting of a parallel configuration of a turn-off type semiconductor switch and a diode.

### Advantageous Effects

According to the present invention, a diversion circuit capable of passing through an overcurrent generated in the event of a short circuit of a power converting apparatus may be provided.

### Brief Description of the Drawings

FIG. 1 is a view illustrating a structure of a power converting apparatus including a plurality of voltage source converters;
FIGs. 2A and 2B are views illustrating a structure of the voltage source converter and a converter arm included in the power converting apparatus;
FIGs. 3A and 3B are views illustrating a concept of diverting an overcurrent, when a short circuit is generated in a DC circuit connected to the power converting apparatus according to an exemplary embodiment;
FIG. 4 is a view illustrating a converter arm to which a protection circuit according to an exemplary embodiment is applied; and
FIG. 5 is a flowchart illustrating steps of a method for converting a power according to an exemplary embodiment.

### Mode for Carrying Out the Invention

Hereinafter, an exemplary embodiment of the present invention will be described in detail with reference to the accompanying drawings.

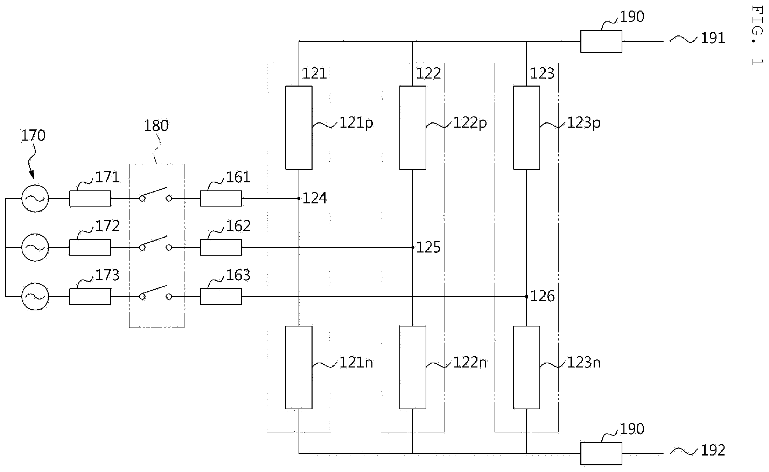

FIG. 1 is a view illustrating a structure of a power converting apparatus 100 including a plurality of voltage source converters.

The power converting apparatus includes the plurality of voltage source converters 121, 122 and 123. Each of the converters includes two converters arms disposed between Alternating Current (AC) connection terminals 124, 125 and 126 and Direct Current (DC) connection terminals 191 and 192. Each of the converter arm circuits may include a voltage source converter consisting of a power semiconductor of a turn-off type. According to an aspect, each of the converter arm circuits may include a plurality of unit modules connected with each other in series.

According to an aspect, an AC power system 170 may be connected to the AC connection terminals 124, 125 and 126. The AC power system 170 generates an AC power, and the generated AC power may be input to the voltage source converters 121, 122 and 123 through a circuit breaker 180 and inductors 161, 162 and 163. The inductors 161, 162 and 163 are modeling of a leakage inductance and an additional inductance of the power converting apparatus. Inductors 171, 172 and 173 are modeling of an inductance of a power system.

The circuit breaker 180 includes a measuring device for sensing currents of the AC connection terminals 124, 125 and 126. When the sensed current is higher than a predetermined limit current, the circuit breaker 180 may perform a shut off operation.

An inductor 190 may be disposed at the DC connection terminals 191 and 192.

The power converting apparatus 100 may convert the DC power provided from the DC connection terminals 191 and 192 into the AC power to provide the AC power to loads 171, 172 and 173 through the AC connection terminals 124, 125 and 126. Or the power converting apparatus 100 may convert the AC power provided from the AC power system 170 through the AC connection terminals 124, 125 and 126 into the DC power to provide the DC power through the DC connection terminals 191 and 192.

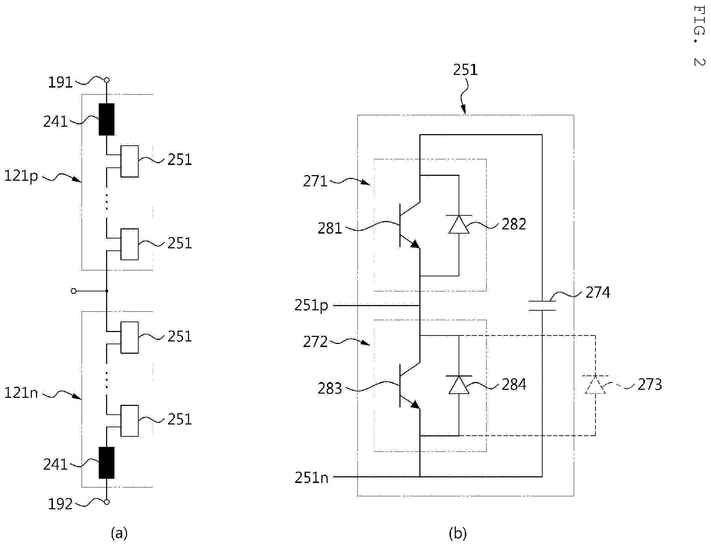

FIGs. 2A and 2B are views illustrating a structure of the voltage source converter and a converter arm included in the power converting apparatus.

FIG. 2A is a view illustrating the voltage source converter 121 included in the power converting apparatus 100. Converter arms 121p and 121n are disposed between the DC connection terminals 191 and 192 and the AC connection terminal 161. In addition, the converter arm includes a plurality of unit modules 251. The voltage source converter may convert the DC power, input through the DC connection terminals 191 and 192, into the AC power using the plurality of unit modules 251, and may provide the converted AC power to the AC power system through the AC connection terminal 161. In addition, the voltage source converter may convert the AC power, input through the AC connection terminal 161, into the DC power using the plurality of unit modules 251, and may provide the converted DC power to a DC circuit through the DC connection terminals 191 and 192.

According to an aspect, the plurality of unit modules 251 are switched from a deactivated state to an activated state, in order to convert the DC into the AC or convert the AC into the DC. According to an aspect, switching time points of each of the unit modules 251 should be accurately controlled so that an output voltage of the voltage source converter may be output through the AC connection terminal 161 as the AC.

For example, each of the unit modules includes an energy storage device, are switched to the activated state or the deactivated state, and thus the voltage source convert may generate a voltage waveform of a step function form. In this case, the switching time points of each of the unit modules are accurately controlled, and thus the required AC voltage output waveform may be generated.

According to an aspect, the converter arm may include at least one of inductor 241.

FIG. 2B is a view illustrating a specific configuration of the unit module 251 included in the converter arm.

The unit module 251 may include a plurality of semiconductor valves 271 and 272, an exemplary embodiment, wherein two semiconductor valves 271 and 272 are connected with each other in series and in a half-bridge method, is shown in FIGs. 2A and 2B. Each of the semiconductor valves 271 and 272 may include semiconductor switches 281 and 283 of a turn-off type and freewheeling diodes 282 and 284 inversely connected to the semiconductor switches 281 and 283 in parallel. In addition, the unit module 251 includes a DC energy storage device 274 connected to the two semiconductor valves 271 and 272, which are connected with each other in series, in parallel.

When a short circuit event is generated in a DC circuit connected to the DC terminal, a fault current is generated in the power converting apparatus. According to an aspect, an increase rate of the fault current is limited by the inductor 241 included in the converter arm unit. The fault current flows from the AC connection terminal 161 to the DC connection terminal 191 through each of the unit modules 251 and the reactor 241 included in the converter arm 121p, or flows from the DC connection terminal 192 to the AC connection terminal 161 through each of the unit modules 251 and the reactor 241 included in the converter arm 121n.

When an overcurrent is applied to the unit module 251, the turn-off semiconductor switches 281 and 282 perform the cut off operation. In this case, the overcurrent flows from an external terminal 251n to an external terminal 251p through the freewheeling diode 284, when the fault current is higher than a current limit of the freewheeling diode, the freewheeling diode is damaged and the unit module 251 is damaged. Because the fault current flows through the same path in all unit modules included in the converter arm to which the fault current is applied not the fault current flows through several unit modules 251, one converter arm is entirely damaged, and thus the power converting apparatus 100 is not operated.

According to an aspect, a path diverting the fault current may be provided by adding a semiconductor protection circuit 273 to the unit module 251. That is, when the turn-off semiconductor 283 is deactivated, current flows through only the freewheeling diode 284 and the semiconductor protection circuit 273. When the short circuit event is generated at a DC side circuit of the power converting apparatus, the fault current may separately flow to the freewheeling diode 284 and the semiconductor protection circuit 273. According to an aspect, the semiconductor protection circuit 273 may have a feature capable of flowing fault current more than the freewheeling diode 284.

The semiconductor protection circuit 273 may include at least one of diode or thyristor. In FIGs. 2A and 2B, the exemplary embodiment wherein the semiconductor protection circuit is added to the unit module 251 is shown,
but, according to an aspect, the semiconductor protection circuit may be added to all of unit modules included in the voltage source converter.

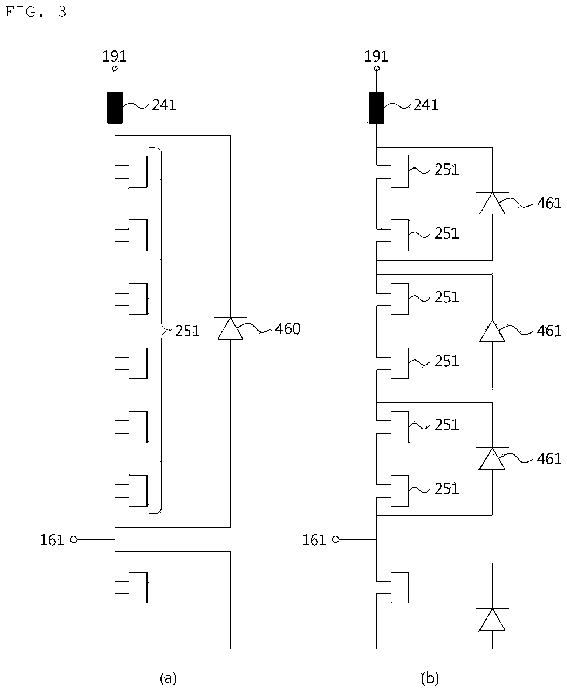

FIGs. 3A and 3B are views illustrating the converter arm to which the protection device according to an exemplary embodiment is applied.

FIG. 3A is a view illustrating the semiconductor protection circuit connected to the plurality of unit modules in parallel, when the converter arms 121p and 121n include the plurality of unit modules 251.

In FIG. 3A, all of the unit modules 251 included in the converter arm are connected with each other in series, and the semiconductor protection circuit is connected to this series connection group in parallel.

When the short circuit event is generated at the DC side circuit of the power converting apparatus, a portion of the fault current may flow through the semiconductor protection circuit 460. In this case, the unit modules 251 included in the converter arm are protected from the fault current.

FIG. 3B is an exemplary embodiment wherein the plurality of unit modules 251 includes a plurality of groups. In FIG. 3B, the unit modules includes three groups. According to an aspect, semiconductor protection circuits 431, 432 and 433 may be connected to voltage source converter groups in parallel, respectively.

When the short circuit event is generated at the DC side circuit, the portion of the fault current flows through the semiconductor protection circuits 431, 432 and 433 connected to the unit module groups in parallel respectively not the converter arm.

According to an aspect, the semiconductor protection circuits 460, 431, 432 and 433 shown in FIGs. 3A and 3B may include at least one thyristor. These semiconductor protection circuits are turned off when the power converting apparatus is normally driven, and are turned on to divert the portion of the fault current when the short circuit event is generated at the DC side and the excessive fault current is applied to the converter arms 121p and 121n.

In addition, each of the voltage source converters 121, 122 and 123 includes the plurality of unit modules as shown in FIG. 2. Here, the plurality of unit modules does not need the semiconductor protection circuit 273.

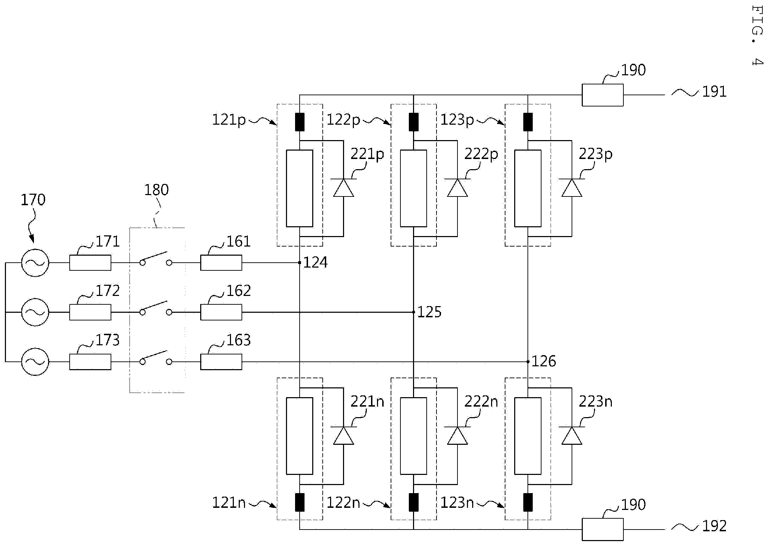

FIG. 4 is a view illustrating a concept of diverting an overcurrent, when the short circuit event is generated in the DC circuit connected to the power converting apparatus according to an exemplary embodiment.

The power converting apparatus may receive the DC power through the DC connection terminals 191 and 192, and may convert the received DC power into the AC power using the plurality of voltage source converters 121, 122 and 123. The converted AC power is provided to the loads 171, 172 and 173 through the AC connection terminals 124, 125 and 126 of the respective voltage source converters.

According to another exemplary embodiment, the power converting apparatus receives the AC power through AC connection terminals 124, 125 and 126, and converts the received AC power into the DC power using the plurality of voltage source converters 121, 122 and 123 to provide the DC power to the DC connection terminals 191 and 192.

According to an exemplary embodiment, when the short circuit event is generated at the DC side of the power converting apparatus, the semiconductor protection circuit may be provided so that the excessive fault current does not flow converter arms 121p, 122p, 123p, 121n, 122n and 123n. That is, the semiconductor protection circuit is not disposed at each of the unit modules 251 as shown in FIGs. 2A and 2B, and may be connected to the converter arms 121p, 122p, 123p, 121n, 122n and 123n, including the plurality of unit modules, in parallel, as shown in FIG. 3A.

In case wherein each of the voltage source converters 121, 122 and 123 includes the two converter arms corresponding to the first voltage source converter and the second voltage source converter, when the failure is generated in the DC circuit connected to the DC connection terminals 191 and 192, the fault current flows to at least one of the converter arms 121p, 122p, 123p, 121n, 122n and 123n, and when the fault current is excessive, thyristor switches of a circuit connected to a corresponding converter arm among the semiconductor protection circuits 221p, 222p, 223p, 221n, 222n and 223n are turned on to divert a respectable amount of the fault current from the converter arm. Thus, the voltage source converter may be protected from the fault current.

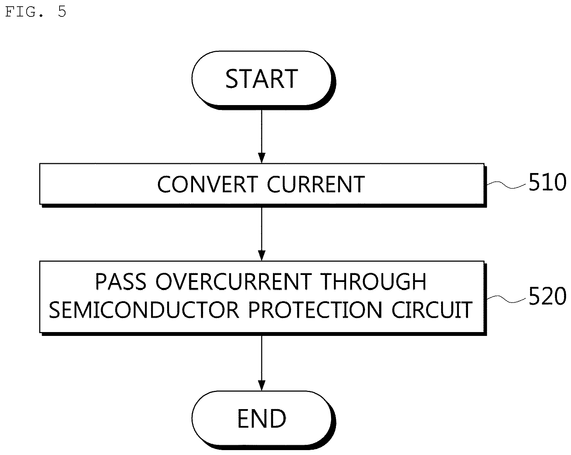

FIG. 5 is a flowchart illustrating steps of a method for converting a power according to an exemplary embodiment.

The converter arm unit may include the AC connection terminal and the DC connection terminal, and may connect the AC connection terminal with the DC connection terminal in series at step 510. According to an aspect, the power converting apparatus may convert the AC received through the AC connection terminal into the DC using the converter arm unit. The converted DC may be output through the DC connection terminal.

According to another aspect, the power converting apparatus may convert the DC received through the DC connection terminal into the AC using the voltage source converter. The converted AC may be output through the AC connection terminal.

According to an aspect, the power converting apparatus may include the plurality of voltage source converters including the first voltage source converter and the second voltage source converter connected with each other in series. Here, the first voltage source converter and the second voltage source converter correspond to the converter arm unit to which the unit modules of the half-bridge method are connected in series. In addition, the unit module may include the two turn-off type semiconductor valves connected with each other in series and a capacitor connected to the two turn-off type semiconductor valves in parallel. In addition, the turn-off type semiconductor valve includes the turn-off type semiconductor and the diode inversely connected to the turn-off type semiconductor in parallel.

The short circuit event may be generated in the DC circuit connected to the DC connection terminal of the power converting apparatus at step 520. In this case, the fault current is applied to the converter arm. According to an aspect, the voltage source converter diverts the portion of the fault current using the semiconductor protection circuit connected to the converter arm unit, corresponding to the first voltage source converter and the second voltage source converter, in parallel, to protect the voltage source converter.

In this case, the semiconductor protection circuit may include at least one thyristor.

The methods according to the exemplary embodiments of the present invention may be implemented in a program instruction form which can be executed by various computer means and may be stored in a computer-readable medium. The computer-readable medium may include a program instruction, a data file, a data structure and so on or combination thereof. The program instruction recorded in the medium may be things specially designed or configured for the present invention, or may be a thing known to be used by a person having ordinary skills in a computer software field.

## Claims

1. A power converting apparatus disposed between an AC power system, which generates an AC power, and a DC circuit, the power converting apparatus comprising:
a voltage source converter (121, 122, 123) comprising an Alternating Current (AC) connection terminal (124, 125, 126) to connect to the AC power system and a Direct Current (DC) connection terminal (191, 192) to connect to the DC circuit, and comprising a converter arm unit (121p, 121n) being disposed between the DC connection terminal and the AC connection terminal and including a first voltage source converter and a second voltage source converter connecting the AC connection terminal with the DC connection terminal in series; and
a semiconductor protection circuit (273) connected to the converter arm unit in parallel, and diverting a fault current flowing through the converter arm unit, when a failure is generated in a DC circuit connected to the DC connection terminal,
wherein the converter arm unit includes a plurality of unit modules (251) connected with each other in series, the unit modules converting the DC power into the AC power or the AC power into the DC power,
wherein the semiconductor protection circuit comprises a thyristor and is connected in parallel to the connection in series of all of the unit modules,
wherein the power converting apparatus is connected to the AC power system using the AC connection terminal and connected to the DC circuit using the DC connection terminal,
wherein the power converting apparatus converts the DC power provided from the DC circuit into the AC power to provide the AC power to the AC power system through the AC connection terminal and converts the AC power provided from the AC power system through the AC connection terminal into the DC power to provide the DC power to the DC circuit through the DC connection terminal.

2. The power converting apparatus as claimed in claim 1, wherein the first voltage source converter and the second voltage source converter are a voltage source converter to which converter unit modules of a half-bridge type are connected in series.

3. The power converting apparatus as claimed in claim 2, wherein each of the converter unit modules comprises a semiconductor valve of a turn-off type including a semiconductor switch of the turn-off type and a diode inversely connected to the semiconductor switch of the turn-off type in parallel.

4. The power converting apparatus as claimed in claim 2, wherein the converter unit module comprises:
semiconductor valves connected with each other in series; and
a DC energy storage device connected to the semiconductor valves, connected with each other in series, in parallel.

5. A method for converting a power in a power converting apparatus disposed between an AC power system, which generates an AC power, and a DC circuit, the method comprising:
converting a Direct Current (DC) into an Alternating Current (AC) or converting the AC into the DC using a converter arm unit (121p, 121n) being disposed between an AC connection terminal (124, 125, 126) to connect to the AC power system and a DC connection terminal (191, 192) to connect to the AC power system, and including a first voltage source converter and a second voltage source converter connecting the AC connection terminal with the DC connection terminal in series; and
diverting a fault current through a semiconductor protection circuit (273) connected to the converter arm unit in parallel and connected to the DC connection terminal, when a failure is generated in a DC circuit connected to the DC connection terminal, the fault current flowing through the converter arm unit,
wherein the converter arm unit includes a plurality of unit modules (251) connected with each other in series, the unit modules converting the DC power into the AC power or the AC power into the DC power,
wherein the semiconductor protection circuit comprises a thyristor and is connected in parallel to the connection in series of all of the unit modules,
wherein the power converting apparatus is connected to the AC power system using the AC connection terminal and connected to the DC circuit using the DC connection terminal,
wherein the power converting apparatus converts the DC power provided from the DC circuit into the AC power to provide the AC power to the AC power system through the AC connection terminal and converts the AC power provided from the AC power system through the AC connection terminal into the DC power to provide the DC power to the DC circuit through the DC connection terminal.

6. The method as claimed in claim 5, wherein the first voltage source converter and the second voltage source converter are a voltage source converter to which converter unit modules of a half-bridge type are connected in series.

7. The method as claimed in claim 6, wherein each of the converter unit modules comprises a semiconductor valve including a semiconductor switch of a turn-off type and a diode inversely connected to the semiconductor switch of the turn-off type in parallel.

8. The method as claimed in claim 6, wherein the converter unit module comprises:
semiconductor valves connected with each other in series; and
a DC energy storage device connected to the semiconductor valves, connected with each other in series, in parallel.

## Patentansprüche

1. Eine Leistungsumwandlungsvorrichtung, welche zwischen einem AC-Leistung-System, welches eine AC-Leistung erzeugt, und einem DC-Schaltkreis angeordnet ist, wobei die Leistungsumwandlungsvorrichtung aufweist:
einen Spannung-Quelle-Konverter (121, 122, 123), welcher einen Wechselstrom-(AC-)Verbindung-Anschluss (124, 125, 126) zum Verbinden mit dem AC-Leistung-System und einen Gleichstrom-(DC-)Verbindung-Anschluss (191, 192) zum Verbinden mit dem DC-Schaltkreis aufweist und welcher eine Konverter-Arm-Einheit (121p, 121n) aufweist, welche zwischen dem DC-Verbindung-Anschluss und dem AC-Verbindung-Anschluss angeordnet ist und einen ersten Spannung-Quelle-Konverter und einen zweiten Spannung-Quelle-Konverter aufweist, welche den AC-Verbindung-Anschluss mit dem DC-Verbindung-Anschluss in Reihe verbinden, und
einen Halbleiter-Schutz-Schaltkreis (273), welcher zu der Konverter-Arm-Einheit parallel geschaltet ist und einen Fehlerstrom, welcher durch die Konverter-Arm-Einheit fließt, umleitet, wenn ein Fehler in einem DC-Schaltkreis erzeugt wird, welcher mit dem DC-Verbindung-Anschluss verbunden ist,
wobei die Konverter-Arm-Einheit eine Mehrzahl von Einheit-Modulen (251) aufweist, welche miteinander in Reihe geschaltet sind, wobei die Einheit-Module die DC-Leistung in die AC-Leistung oder die AC-Leistung in die DC-Leistung umwandeln,
wobei der Halbleiter-Schutz-Schaltkreis einen Thyristor aufweist und parallel zur Reihenschaltung von allen der Einheit-Module geschaltet ist,
wobei die Leistungsumwandlungsvorrichtung mit dem AC-Leistung-System unter Verwendung des AC-Verbindung-Anschlusses verbunden ist und mit dem DC-Schaltkreis unter Verwendung des DC-Verbindung-Anschlusses verbunden ist,
wobei die Leistungsumwandlungsvorrichtung die DC-Leistung, welche von dem DC-Schaltkreis bereitgestellt wird, in die AC-Leistung umwandelt, um die AC-Leistung dem AC-Leistung-System durch den AC-Verbindung-Anschluss bereitzustellen, und die AC-Leistung, welche von dem AC-Leistung-System durch den AC-Verbindung-Anschluss bereitgestellt wird, in die DC-Leistung umwandelt, um die DC-Leistung dem DC-Schaltkreis durch den DC-Verbindung-Anschluss bereitzustellen.

2. Die Leistungsumwandlungsvorrichtung wie in Anspruch 1 beansprucht, wobei der erste Spannung-Quelle-Konverter und der zweite Spannung-Quelle-Konverter ein Spannung-Quelle-Konverter sind, mit welchem Konverter-Einheit-Module eines Halbbrücke-Typs in Reihe geschaltet sind.

3. Die Leistungsumwandlungsvorrichtung wie in Anspruch 2 beansprucht, wobei jedes der Konverter-Einheit-Module ein Halbleiter-Ventil eines Ausschalt-Typs aufweist, welches einen Halbleiter-Schalter des Ausschalt-Typs und eine Diode, welche invers zu dem Halbleiter-Schalter des Ausschalt-Typs parallel geschaltet ist, aufweist.

4. Die Leistungsumwandlungsvorrichtung wie in Anspruch 2 beansprucht, wobei das Konverter-Einheit-Modul aufweist:
Halbleiter-Ventile, welche miteinander in Reihe verbunden sind, und
eine DC-Energie-Speicher-Vorrichtung, welche mit den Halbleiter-Ventilen, die miteinander in Reihe verbunden sind, parallel geschaltet ist.

5. Ein Verfahren zum Umwandeln einer Leistung in einer Leistungsumwandlungsvorrichtung, welche zwischen einem AC-Leistung-System, welches eine AC-Leistung erzeugt, und einem DC-Schaltkreis angeordnet ist, wobei das Verfahren aufweist:
Umwandeln eines Gleichstroms (DC) in einen Wechselstrom (AC) oder Umwandeln des AC in den DC unter Verwendung einer Konverter-Arm-Einheit (121p, 121n), welche zwischen einem AC-Verbindung-Anschluss (124, 125, 126) zum Verbinden mit dem AC-Leistung-System und einem DC-Verbindung-Anschluss (191, 192) zum Verbinden mit dem AC-Leistung-System angeordnet ist, und welche einen ersten Spannung-Quelle-Konverter und einen zweiten Spannung-Quelle-Konverter aufweist, welche den AC-Verbindung-Anschluss mit dem DC-Verbindung-Anschluss in Reihe verbinden, und
Umleiten eines Fehlerstroms durch einen Halbleiter-Schutz-Schaltkreis (273), welcher parallel zu der Konverter-Arm-Einheit geschaltet ist und mit dem DC-Verbindung-Anschluss verbunden ist, wenn ein Fehler in einem DC-Schaltkreis erzeugt wird, welcher mit dem DC-Verbindung-Anschluss verbunden ist, wobei der Fehlerstrom durch die Konverter-Arm-Einheit fließt,
wobei die Konverter-Arm-Einheit eine Mehrzahl von Einheit-Modulen (251) aufweist, welche miteinander in Reihe geschaltet sind, wobei die Einheit-Module die DC-Leistung in die AC-Leistung oder die AC-Leistung in die DC-Leistung umwandeln,
wobei der Halbleiter-Schutz-Schaltkreis einen Thyristor aufweist und parallel geschaltet ist zur Reihenschaltung von allen der Einheit-Module,
wobei die Leistungsumwandlungsvorrichtung mit dem AC-Leistung-System unter Verwendung des AC-Verbindung-Anschlusses verbunden ist und mit dem DC-Schaltkreis unter Verwendung des DC-Verbindung-Anschlusses verbunden ist,
wobei die Leistungsumwandlungsvorrichtung die DC-Leistung, welche von dem DC-Schaltkreis bereitgestellt wird, in die AC-Leistung umwandelt, um die AC-Leistung dem AC-Leistung-System durch den AC-Verbindung-Anschluss bereitzustellen, und die AC-Leistung, welche von dem AC-Leistung-System durch den AC-Verbindung-Anschluss bereitgestellt wird, in die DC-Leistung umwandelt, um die DC-Leistung dem DC-Schaltkreis durch den DC-Verbindung-Anschluss bereitzustellen.

6. Das Verfahren wie in Anspruch 5 beansprucht, wobei der erste Spannung-Quelle-Konverter und der zweite Spannung-Quelle-Konverter ein Spannung-Quelle-Konverter sind, mit welchem Konverter-Einheit-Module eines Halbbrücke-Typs in Reihe geschaltet sind.

7. Das Verfahren wie in Anspruch 6 beansprucht, wobei jedes der Konverter-Einheit-Module ein Halbleiter-Ventil aufweist, welches einen Halbleiter-Schalter eines Ausschalt-Typs und eine Diode, welche invers zu dem Halbleiter-Schalter des Ausschalt-Typs parallel geschaltet ist, aufweist.

8. Das Verfahren wie in Anspruch 6 beansprucht, wobei das Konverter-Einheit-Modul aufweist:
Halbleiter-Ventile, welche miteinander in Reihe verbunden sind, und
eine DC-Energie-Speicher-Vorrichtung, welche zu den Halbleiter-Ventilen, welche miteinander in Reihe verbunden sind, parallel geschaltet ist.

## Revendications

1. Appareil de conversion de puissance disposé entre un système d'alimentation en courant alternatif, CA, qui génère un courant alternatif, et un circuit en courant continu, CC, l'appareil de conversion de puissance comprenant :
un convertisseur de source de tension (121, 122, 123) comprenant une borne de connexion de courant alternatif (CA) (124, 125, 126) à connecter au système d'alimentation CA, et une borne de connexion de courant continu (CC) (191, 192) à connecter au circuit CC, et comprenant une unité de bras de convertisseur (121p, 121n) disposée entre la borne de connexion de courant CC et la borne de connexion de courant CA et incluant un premier convertisseur de source de tension et un second convertisseur de source de tension connectant la borne de connexion de courant CA à la borne de connexion de courant CC en série ; et
un circuit de protection semi-conducteur (273) connecté à l'unité de bras de convertisseur en parallèle, et déviant un courant de défaut circulant à travers l'unité de bras de convertisseur, lorsqu'une défaillance est générée dans un circuit CC connecté à la borne de connexion de courant CC ;
dans lequel l'unité de bras de convertisseur inclut une pluralité de modules unitaires (251) connectés les uns aux autres en série, les modules unitaires convertissant le courant continu en courant alternatif, ou le courant alternatif en courant continu ;
dans lequel le circuit de protection semi-conducteur comprend un thyristor et est connecté en parallèle à la connexion en série de tous les modules unitaires ;
dans lequel l'appareil de conversion de puissance est connecté au système d'alimentation CA en utilisant la borne de connexion de courant CA et est connecté au circuit CC en utilisant la borne de connexion de courant CC ;
dans lequel l'appareil de conversion de puissance convertit le courant continu, fourni par le circuit CC, en courant alternatif, en vue de fournir le courant alternatif au système d'alimentation CA à travers la borne de connexion de courant CA, et convertit le courant alternatif, fourni par le système d'alimentation CA, à travers la borne de connexion de courant CA, en courant continu, en vue de fournir le courant continu au circuit CC à travers la borne de connexion de courant CC.

2. Appareil de conversion de puissance selon la revendication 1, dans lequel le premier convertisseur de source de tension et le second convertisseur de source de tension correspondent à un convertisseur de source de tension auquel sont connectés en série des modules unitaires de convertisseur du type demi-pont.

3. Appareil de conversion de puissance selon la revendication 2, dans lequel chacun des modules unitaires de convertisseur comprend une valve à semi-conducteur du type à désactivation incluant un commutateur à semi-conducteur du type à désactivation, et une diode inversement connectée en parallèle au commutateur à semi-conducteur du type à désactivation.

4. Appareil de conversion de puissance selon la revendication 2, dans lequel le module unitaire de convertisseur comprend :
des valves à semi-conducteur connectées en série les unes aux autres ; et
un dispositif de stockage d'énergie CC connecté en parallèle aux valves à semi-conducteur connectées en série les unes aux autres.

5. Procédé de conversion d'une puissance dans un appareil de conversion de puissance disposé entre un système d'alimentation en courant alternatif, CA, qui génère un courant alternatif, et un circuit de courant continu, CC, le procédé comprenant les étapes ci-dessous consistant à :
convertir un courant continu (CC) en un courant alternatif (CA) ou convertir le courant alternatif en courant continu en utilisant une unité de bras de convertisseur (121p, 121n) disposée entre une borne de connexion de courant CA (124, 125, 126) à connecter au système d'alimentation CA, et une borne de connexion de courant CC (191, 192) à connecter au système d'alimentation CA, et incluant un premier convertisseur de source de tension et un second convertisseur de source de tension connectant la borne de connexion de courant CA à la borne de connexion de courant CC en série ; et
dévier un courant de défaut à travers un circuit de protection semi-conducteur (273) connecté en parallèle à l'unité de bras de convertisseur et connecté à la borne de connexion de courant CC, lorsqu'une défaillance est générée dans un circuit CC connecté à la borne de connexion de courant CC, le courant de défaut circulant à travers l'unité de bras de convertisseur,
dans lequel l'unité de bras de convertisseur inclut une pluralité de modules unitaires (251) connectés les uns aux autres en série, les modules unitaires convertissant le courant continu en courant alternatif, ou le courant alternatif en courant continu ;
dans lequel le circuit de protection semi-conducteur comprend un thyristor et est connecté en parallèle à la connexion en série de tous les modules unitaires ;
dans lequel l'appareil de conversion de puissance est connecté au système d'alimentation CA en utilisant la borne de connexion de courant CA et est connecté au circuit CC en utilisant la borne de connexion de courant CC ;
dans lequel l'appareil de conversion de puissance convertit le courant continu, fourni par le circuit CC, en courant alternatif, en vue de fournir le courant alternatif au système d'alimentation CA à travers la borne de connexion de courant CA, et convertit le courant alternatif, fourni par le système d'alimentation CA, à travers la borne de connexion de courant CA, en courant continu, en vue de fournir le courant continu au circuit CC à travers la borne de connexion de courant CC.

6. Procédé selon la revendication 5, dans lequel le premier convertisseur de source de tension et le second convertisseur de source de tension correspondent à un convertisseur de source de tension auquel sont connectés en série des modules unitaires de convertisseur du type demi-pont.

7. Procédé selon la revendication 6, dans lequel chacun des modules unitaires de convertisseur comprend une valve à semi-conducteur incluant un commutateur à semi-conducteur du type à désactivation, et une diode inversement connectée en parallèle au commutateur à semi-conducteur du type à désactivation.

8. Procédé selon la revendication 6, dans lequel le module unitaire de convertisseur comprend :
des valves à semi-conducteur connectées en série les unes aux autres ; et
un dispositif de stockage d'énergie CC connecté en parallèle aux valves à semi-conducteur connectées en série les unes aux autres.
